# EUROPEAN PATENT APPLICATION

(11) **EP 4 373 109 A1**
(43) Date of publication of application: **22.05.2024**
(21) Application number: 22887330.3
(22) Date of filing: 05.09.2022
(51) Int. Cl.: H04N 23/00, H05K 1/14, H05K 3/46

(54) **CAMERA MODULE WITH IMPROVED DEGREE OF DESIGN FREEDOM, AND ELECTRONIC DEVICE COMPRISING SAME**

(30) Priority: 01.11.2021 KR 20210148199
(71) Applicant: Samsung Electronics Co., Ltd., Suwon-si, Gyeonggi-do 16677 (KR)
(72) Inventor: KIM, Byoungjun, Suwon-si Gyeonggi-do 16677 (KR); PARK, Gunhee, Suwon-si Gyeonggi-do 16677 (KR); RHEEM, Jaewook, Suwon-si Gyeonggi-do 16677 (KR)
(74) Representative: Appleyard Lees IP LLP
(86) International application number: PCT/KR2022/013261
(87) International publication number: WO 2023/075126

(57) **Abstract**

According to an embodiment, a camera module comprises: a camera; a printed circuit board including a rigid area, which includes a first edge and a second edge extending perpendicularly to the first edge, and a flexible area, which extends from the rigid area; and a connector, wherein the flexible area is foldable on one surface of the printed circuit board along a folding axis passing through the point at which the first edge and the second edge make contact, and the connector is movable between a position facing the first edge and a position facing the second edge, according to the folding of the flexible region along the folding axis.

## Description

### [Technical Field]

Various embodiments relate to a camera module with an improved degree of design freedom, and an electronic device comprising the same.

### [Background Art]

In response to a user's request for an electronic device to be equipped with various functions, the electronic device may include a camera. The camera may be disposed at various positions of the electronic device. For example, the camera may be disposed on a front surface of the electronic device on which a display is disposed, or may be embedded in the electronic device to face a rear surface facing the front surface.

The camera may be manufactured in a form of a module including a printed circuit board before being embedded in the electronic device. The camera module may include a connector electrically connecting the printed circuit board and another printed circuit board of the electronic device. The camera module may be mounted in the electronic device by connecting the connector to the other printed circuit board in the electronic device.

### [Disclosure]

### [Technical Problem]

A camera module may include a connector on a cable extending from an edge of a camera. For example, in case that a position of the connector is fixed to a side surface of the camera, when the camera module is accommodated in a mounting space of the electronic device, the connector of the camera module may not be located at a point corresponding to a connector of a printed circuit board of the electronic device. Since the connector has different positions depending on the mounting space of the electronic device, the camera module may have to be manufactured to have a cable and connector extending to different positions depending on a model of the electronic device. Even since a camera module of the same specification has a different cable and connector depending on the model of the electronic device, it may be difficult to produce in the same production line, so there may be an increase in an equipment cost and difficulties in a small quantity production.

Various embodiments may provide a camera module with an improved degree of design freedom, and an electronic device comprising the same.

The technical problems to be achieved in this document are not limited to those described above, and other technical problems not mentioned herein will be clearly understood by those having ordinary knowledge in the art to which the present disclosure belongs, from the following description.

### [Technical Solution]

According to an embodiment, a camera module may comprise a camera. According to an embodiment, the camera module may comprise a printed circuit board on which the camera is disposed, including a rigid region including a first edge and a second edge extending perpendicular to the first edge and a flexible region extending from the rigid region. According to an embodiment, the camera module may comprise a connector connected to the flexible region of the printed circuit board. According to an embodiment, the flexible region may by foldable on one surface of the printed circuit board with respect to a folding axis passing through a point where the first edge and the second edge contact, and the connector may be movable between a position facing the first edge and a position facing the second edge as the flexible region is folded with respect to the folding axis.

According to an embodiment, an electronic device may comprise a housing. According to an embodiment, the electronic device may comprise a first printed circuit board disposed inside the housing. According to an embodiment, the electronic device may comprise a camera module disposed inside the housing. According to an embodiment, the camera module may include a camera. According to an embodiment, the camera module may include a second printed circuit board on which the camera is disposed, including a rigid region including a first edge and a second edge extending perpendicular to the first edge and a flexible region extending from the rigid region. According to an embodiment, the camera module may include a connector connected to one end of the flexible region and electrically connecting the camera module and the first printed circuit board. According to an embodiment, the flexible region may be foldable on one surface of the second printed circuit board with respect to a folding axis passing through a point where the first edge and the second edge contact. According to an embodiment, the connector may be movable between a position facing the first edge and a position facing the second edge as the flexible region is folded with respect to the folding axis.

### [Advantageous Effects]

According to an embodiment, a flexible region of a camera module is foldable, so that when the camera module is mounted on an electronic device, a connector of the camera module can be moved to a point corresponding to a position of a connector on a printed circuit board of the electronic device. According to an embodiment, the camera module can be mounted in various electronic devices because a position of the connector can be changed, and thus a degree of design freedom may be improved. According to an embodiment, the electronic device includes a camera module with an improved degree of design freedom, thereby reducing restrictions on a space in which the camera module is disposed, thereby saving a mounting space in which internal components are mounted.

The effects that can be obtained from the present disclosure are not limited to those described above, and any other effects not mentioned herein will be clearly understood by those having ordinary knowledge in the art to which the present disclosure belongs, from the following description.

### [Description of the Drawings]

FIG. 1 is a block diagram illustrating an electronic device in a network environment according to various embodiments.
Fig. 2 is a block diagram illustrating the camera module according to various embodiments.
FIG. 3 shows an example of an electronic device according to an embodiment.
FIG. 4A is an exploded prospective view of a camera module according to an embodiment.
FIG. 4B is a diagram illustrating an example of a state in which a flexible region of a camera module is folded according to an embodiment.
FIG. 4C is a diagram illustrating another example of a state in which a flexible region of a camera module is folded according to an embodiment.
FIG. 5 is a section view illustrating an example of a camera module cut along line A-A' of FIG. 4A according to an embodiment.
FIG. 6 illustrates an example of a method of manufacturing a camera module according to an embodiment.
FIG. 7A is a section view illustrating a cross-section of a camera module according to an embodiment.
FIG. 7B is a diagram illustrating an example of a state in which a flexible region of a camera module is folded according to an embodiment.
FIG. 8 is a diagram illustrating an example of a state in which a flexible region of a camera module is folded according to an embodiment.
FIG. 9 is a section view illustrating a cross-section of a camera module according to an embodiment.
FIG. 10A is a section view illustrating a cross-section of a camera module according to an embodiment.
FIG. 10B is a diagram illustrating an example of a state in which a flexible region of a camera module is folded according to an embodiment.
FIG. 11A is a diagram illustrating an example of a state in which a flexible region of a camera module is unfolded, according to an embodiment.
FIG. 11B is a section view illustrating an example of a camera module cut along line B-B' of FIG. 11A according to an embodiment.
FIG. 12A is a diagram illustrating an example of a state in which a flexible region of a camera module is folded according to an embodiment.
FIG. 12B is a section view illustrating an example of a camera module cut along line C-C' of FIG. 12A according to an embodiment.

### [Mode for Invention]

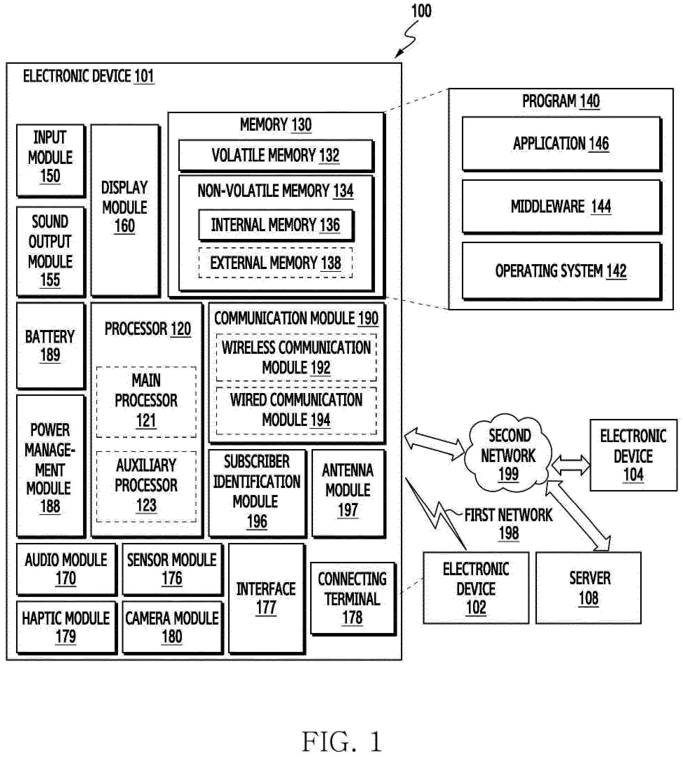

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

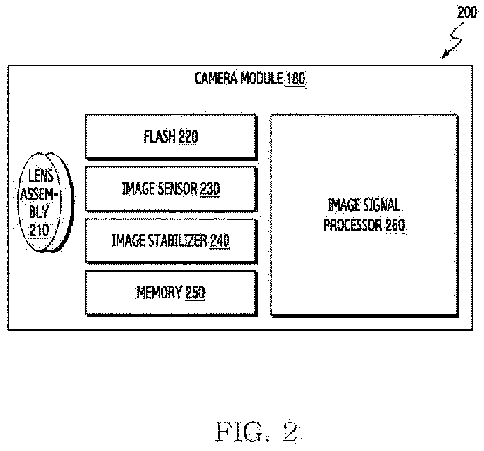

Fig. 2 is a block diagram 200 illustrating the camera module 180 according to various embodiments.

Referring to Fig. 2, the camera module 180 may include a lens assembly 210, a flash 220, an image sensor 230, an image stabilizer 240, memory 250 (e.g., buffer memory), or an image signal processor 260. The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp. The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display module 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules180 may form a rear camera. For another example, a plurality of camera modules 180 may include at least one of a depth camera, a wide-angle camera, an ultra-wide-angle camera, or a telephoto camera.

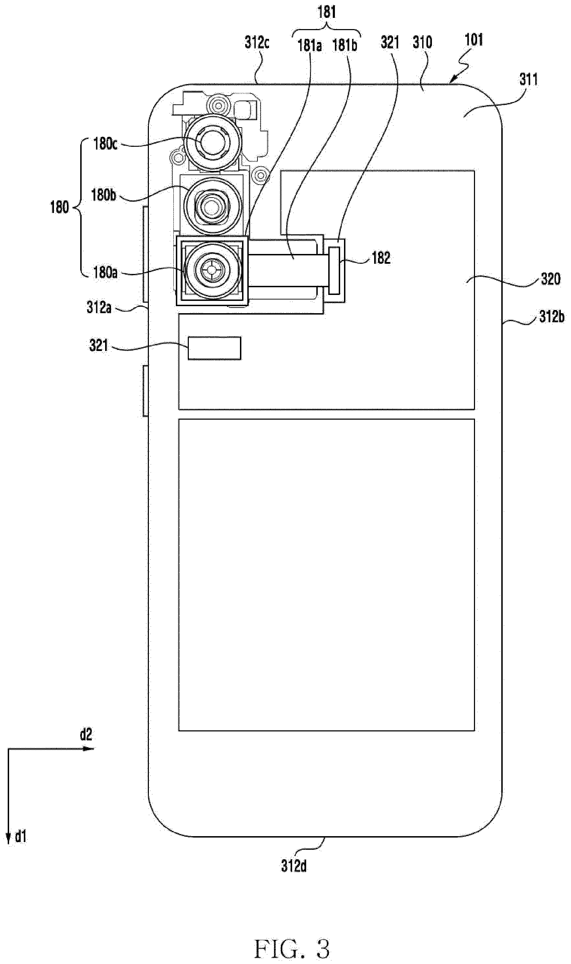

FIG. 3 shows an example of an electronic device according to an embodiment.

Referring to FIG. 3, according to an embodiment, an electronic device 101 may include a housing 310, a first printed circuit board 320, and a camera module 180.

The housing 310 may form an overall appearance of the electronic device 101 and may form an internal space in which various components of the electronic device 101 are mounted. For example, the housing 310 may include a front surface (not illustrated) on which a display (e.g., a display module 160 of FIG. 1) is disposed, a rear surface 311 facing the front surface, and a side surface 312 connecting edges of the front surface and the rear surface 311. The front surface, the rear surface 311, and the side surface 312 of the housing 310 may form an internal space of the housing 310.

According to an embodiment, the side surface 312 may include a first side surface 312a extending in a first direction d1, a second side surface 312b spaced apart from the second side surface 312a and extending in the first direction d1 to be parallel to the first side surface 312a, a third side surface 312c extending from one end of the first side surface 312a to one end of the second side surface 312b along a second direction d2 substantially perpendicular to the first direction d1 and a fourth side surface 312d extending from the other end of the first side surface 312a to the other end of the second side surface 312b along the second direction d2. For example, the first side surface 312a and the second side surface 312b may extend longer than the third side surface 312c and the fourth side surface 312d so that the electronic device 101 has a length.

The first printed circuit board 320 may form an electrical connection between components of the electronic device 101 that performs an overall operation of the electronic device 101. For example, the first printed circuit board 320 may be a main circuit board of the electronic device 101 on which a processor (e.g., a processor 120 of FIG. 1) is disposed. According to an embodiment, the first printed circuit board 320 may form an electrical connection between various electronic components (e.g., the camera module 180) disposed on the first printed circuit board 320 or various components of the electronic device 101 disposed outside the first printed circuit board 320. According to an embodiment, the first printed circuit board 320 may be electrically connected to various components of an electronic device 301 through a connection member. For example, the connection member may include a coaxial cable connector, a board to board connector, an interposer, or a flexible printed circuit board (FPCB).

According to an embodiment, the first printed circuit board 320 may include a first connector 321. The first connector 321 may be, for example, a socket connector among the socket connector and a plug connector of the board-to-board connector. The first connector 321 may be disposed at various positions on the first printed circuit board 320 depending on an internal structural design of the electronic device 101. For example, the first connector 321 may be disposed on the first printed circuit board 320 to be spaced apart from the camera module 180 in the first direction d1 or to be spaced apart along the second direction d2.

The camera module 180 may be mounted in the electronic device 101. For example, the camera module 180 may be disposed to face a front surface of the electronic device 101. For another example, the camera module 180 may be disposed to face a rear surface 310b of the electronic device 101, and at least part of it may be exposed to the outside of the electronic device 101. According to an embodiment, the camera modules 180 may be a plurality. A plurality of camera modules 180a, 180b, and 180c may perform different functions. For example, the plurality of camera modules 180a, 180b, and 180c may be at least one of a depth camera, a wide-angle camera, an ultra-wide-angle camera, and a telephoto camera.

According to an embodiment, the camera module 180 may be mounted in the electronic device 101 by being connected to the first printed circuit board 320 of the electronic device 101 after manufacturing is completed. For example, the camera module 180 may be manufactured to include a second printed circuit board 181 and a second connector 182 electrically connected to the second printed circuit board 181. For example, the second connector 182 may be the plug connector among the socket connector and the plug connector of the board-to-board connector. The second printed circuit board 181 may include a rigid region 181a in which overall components of the camera module 180 are disposed and a flexible region 181b extending from the rigid region 181a and connected to the connector 182. The camera module 180 whose manufacture has been completed may be mounted in the electronic device 101 in a manner that the rigid region 181a is accommodated inside the electronic device 101 and the second connector 182 is coupled to the first connector 321 of the first printed circuit board 320.

The rigid region 181a of the camera module 180 may be a region in which the overall components of the camera module 180 are disposed. The flexible region 181b of the camera module 180 may be referred to as a cable extending from the rigid region 181a to electrically connect the first printed circuit board 320 and the camera module 180.

In general, the flexible region 181b of the camera module 180 may be manufactured not to move with respect to the rigid region 181a. As the flexible region 181b is not movable, a position of the second connector 182 with respect to the rigid region 181a may be fixed. For example, in case that the flexible region 181b extends from the rigid region 181a along the second direction d2, the second connector 182 may be spaced apart from the rigid region 181a along the second direction d2. When the rigid region 181a of the camera module 180 is accommodated in the electronic device 101, in case that there is no first connector 321 at a point spaced apart from the rigid region 181a along the second direction d2, the camera module 180 may not be electrically connected to the first printed circuit board 320. In case that the first printed circuit board 320 and the camera module 180 are not electrically connected, the camera module 180 may not be able to perform a pre-designed function in the electronic device 101.

As described above, in case that the flexible region 181b of the camera module 180 is not movable with respect to the rigid region 181a, the camera module 180 may not be able to electrically being connected to the first printed circuit board 320 and may not be able to perform the pre-designed function. Since the internal structure of the electronic device 101 varies for each electronic device 101, the design of the camera module 180 may be changed to have a structure corresponding to the internal structure of the electronic device 101 that is to be mounting target. Changing the structural design of the camera module 180 depending on the internal structure of the electronic device 101 may be wasteful. Hereinafter, a structure of the camera module 180 with an improved degree of design freedom that may be mounted in various internal structures of the electronic device 101 is described.

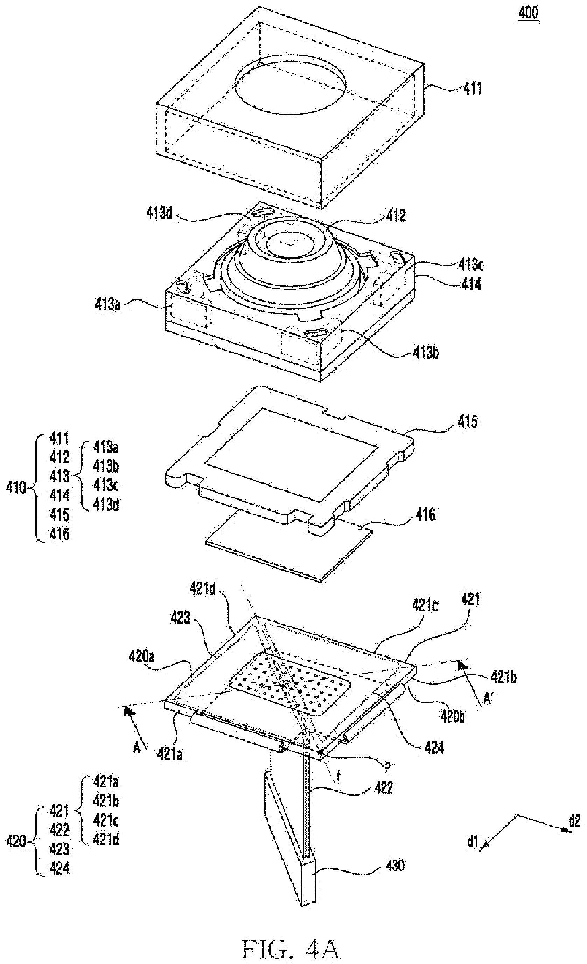

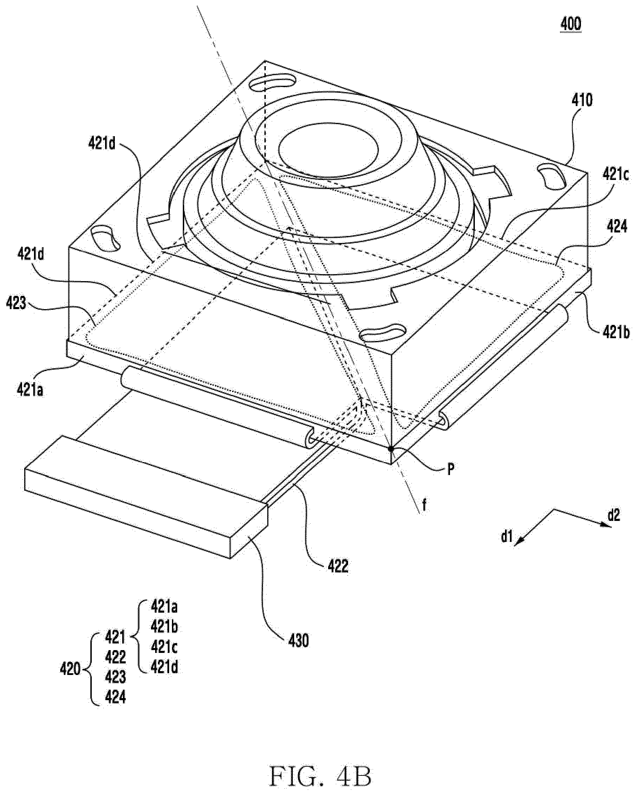

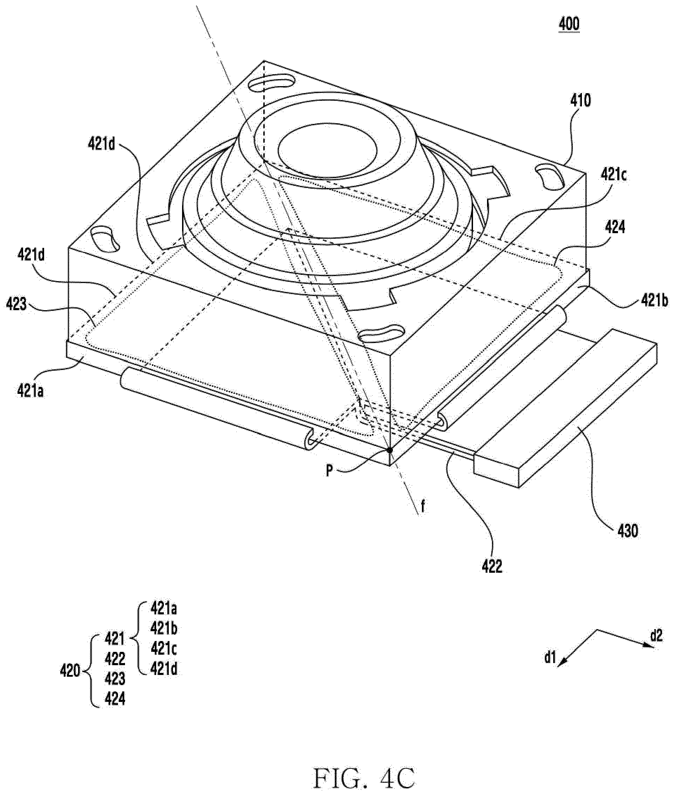

FIG. 4A is an exploded prospective view of a camera module according to an embodiment, FIG. 4B is a diagram illustrating an example of a state in which a flexible region of a camera module is folded according to an embodiment, and FIG. 4C is a diagram illustrating another example of a state in which a flexible region of a camera module is folded according to an embodiment.

Referring to FIGS. 4A, 4B, and 4C, according to an embodiment, a camera module 400 (e.g., a camera module 180 of FIG. 1) may include a camera 410, a printed circuit board 420, and a connector 430.

The camera 410 may obtain an image by receiving light emitted from a subject located outside an electronic device (e.g., an electronic device 101 of FIG. 1). According to an embodiment, the camera 410 may be disposed on a top surface 420a of the printed circuit board 420. According to an embodiment, the camera 410 may include a case 411, a lens assembly 412 (e.g., a lens assembly 210 of FIG. 2), an actuator 413, a shield can 414, an optical filter 415, and an image sensor 416 (e.g., an image sensor 230 of FIG. 2).

The case 411 may protect components of the camera 410 by being disposed on the printed circuit board 420. According to an embodiment, the case 411 may surround the lens assembly 412, the actuator 413, the shield can 414, the optical filter 415, and the image sensor 416.

The lens assembly 412 may collect light emitted from an external subject of the electronic device 101. According to an embodiment, the lens assembly 412 may be disposed on the printed circuit board 420 to be movable in the case 411. For example, the lens assembly 412 may move along a gaze direction of the camera module 400 (e.g., a direction from a bottom surface 420b of the printed circuit board 420 toward a top surface 420a of the printed circuit board 420) or a direction opposite to the gaze direction of the camera module 400 (e.g., a direction from the top surface 420a of the printed circuit board 420 toward the bottom surface 420b of the printed circuit board 420). For another example, the lens assembly 412 may move in a direction toward any one of a plurality of edges 421a, 421b, 421c, and 421d of the printed circuit board 420.

The actuator 413 may provide driving force to the lens assembly 412 so that the lens assembly 412 moves. According to an embodiment, the actuator 413 may move the lens assembly 412 in the gaze direction of the camera module 400 or in the direction opposite to the gaze direction, for auto focusing. The actuator 413 may adjust the focal length of the camera module 400 by adjusting the distance between the lens assembly 412 and the image sensor 416 by moving the lens assembly 412. According to an embodiment, the actuator 413 may include a plurality of operating members 413a, 413b, 413c, and 413d that provide the driving force to the lens assembly 412. For example, the plurality of operating members 413a, 413b, 413c, and 413d may each be a coil disposed outside the lens assembly 412 or a magnet interacting with the coil. The plurality of operating members 413a, 413b, 413c, and 413d may generate a driving force that moves the lens assembly 412 through a Lorentz force generated when a current flows in the coil located in a magnetic field of the magnet.

The shield can 414 may shield an electromagnetic wave attempting to penetrate into the actuator 413 or an electromagnetic wave emitted from the actuator 413. According to an embodiment, the shield can 414 may shield an electromagnetic wave transmitted to the camera module 400 by being electrically connected to a ground line of the printed circuit board 420. For example, the shield can 414 prevents an electromagnetic wave generated from the actuator 413 from affecting other electronic components of the electronic device 101 by shielding an electromagnetic wave generated during operation of the actuator 413. For another example, the shield can 414 may prevent an electromagnetic wave emitted from the other electronic components (e.g., an antenna module 197 of FIG. 1) of the electronic device 101 from interfering with the operation of the actuator 413. According to an embodiment, the shield can 414 may surround the actuator 413 in the case 411. For example, the shield can 414 may be manufactured with a metal material such as copper or aluminum, or may be manufactured with a composite material in which a filler (e.g., carbon fiber, carbon black, carbon nanotube (CNT), or Nickel coated graphite, which are a polymer material) is added to the metal material.

The optical filter 415 may transmit the filtered light to the image sensor 416 by selectively filtering light having a specific wavelength. For example, since infrared rays passing through the lens assembly 412 may cause chromatic aberration and resolution deterioration, the optical filter 415 may be an infrared filter that prevents infrared transmission to the image sensor 416. According to an embodiment, the optical filter 415 may be interposed between the lens assembly 412 and the image sensor 416.

The image sensor 416 may receive light from the lens assembly 412 and may generate an electrical signal for image generation based on the received light. According to an embodiment, the image sensor 416 may be disposed on the top surface 420a of the printed circuit board 420. For example, the image sensor 416 may include a Charge Coupled Device (CCD) or a Complementary Metal Oxide Semiconductor (CMOS).

The printed circuit board 420 may form electrical connections between various components configuring the camera module 400. The printed circuit board 420 may include a plurality of layers on which conductive patterns are printed. For example, the conductive patterns included in the printed circuit board 420 may be a signal line forming an electrical circuit between various components of the camera module 400 or a ground line forming a ground of the printed circuit board 420.

According to an embodiment, the printed circuit board 420 may include a rigid region 421 and a flexible region 422. The rigid region 421 has rigidity and may support the camera 410 disposed on the printed circuit board 420. According to an embodiment, the rigid region 421 may include the plurality of edges 421a, 421b, 421c, and 421d facing in different directions. For example, the rigid region 421 may include the first edge 421a facing a first direction, the second edge 421b extending substantially perpendicular to the first edge 421a and facing a second direction distinct from the first direction, the third edge 421c parallel to the first edge 421a and facing in a direction opposite to the first edge 421a, and the fourth edge 421d parallel to the second edge 421b and facing in a direction opposite to the second edge 421b . According to an embodiment, the rigid region 421 may have an overall rectangular shape, but is not limited thereto. For example, as a point at which the plurality of edges 421a, 421b, 421c, and 421d contact each other is curved, the rigid region 421 may have a rounded rectangular shape.

According to an embodiment, the flexible region 422 may have flexibility compared to the rigid region 421. The flexible region 422 includes the signal line and may function as a cable for transmitting electrical signals between the camera module 400 and electronic components outside the camera module 400. For example, the flexible region 422 may include a power line for supplying power transmitted from a battery (e.g., a battery 189 of FIG. 1) and may supply power to the camera 410 through the rigid region 421. For another example, the flexible region 422 may function as a passage through which an image signal obtained from the camera 410 moves to a first printed circuit board (e.g., a first printed circuit board 320 of FIG. 3) or a control signal generated from a processor (e.g., a processor 120 of FIG. 1) moves to the camera 410.

The connector 430 may electrically connect the printed circuit board 420 and the first printed circuit board 320 of the electronic device 101. According to an embodiment, the connector 430 may be connected to one end of the flexible region 422. For example, the connector 430 may be a plug connector among a socket connector and the plug connector of the board-to-board connector.

According to an embodiment, the flexible region 422 may be foldable with respect to the rigid region 421. For example, the flexible region 422 may be folded with respect to the rigid region 421 based on a virtual folding axis f passing through a point p at which the first edge 421a and the second edge 421b contact each other. The folding axis f may be a virtual line extending in a direction parallel to a diagonal of the rigid region 421, but is not limited thereto. For another example, the folding axis f may be a line passing through one of the point p at which the first edge 421a and the second edge 421b contact each other and a point of the third edge 421c. For still another example, the folding axis f may be a line passing through one of the point p at which the first edge 421a and the second edge 421b contact each other and a point of the fourth edge 421d.

According to an embodiment, the flexible region 422 may extend from the bottom surface 420b of the printed circuit board 420 in a direction substantially perpendicular to the bottom surface 420b of the printed circuit board 420 in an unfolded state. The unfolded state may mean a state in which the flexible region 422 does not substantially have curvature. For example, the flexible region 422 may extend in a straight line from the bottom surface 420b of the printed circuit board 420 to the connector 430 in the unfolded state. According to an embodiment, the flexible region 422 may be formed by some of a plurality of layers included in the printed circuit board 420. For example, some of the plurality of layers included in the printed circuit board 420 may protrude from the first edge 421a or the second edge 421b of the rigid region 421 and may extend to the bottom surface 420b of the printed circuit board 420 along an outer surface of the rigid region 421. Some of the plurality of layers extending to the bottom surface 420b may form the flexible region 422, by extending from the folding axis f in a direction substantially perpendicular to the bottom surface 420b of the printed circuit board 420.

According to an embodiment, the rigid region 421 may include a first region 423 and a second region 424 facing each other with respect to the folding axis f. As the flexible region 422 is folded with respect to the folding axis f, it may be movable between a position facing the first region 423 of the rigid region 421 and a position facing the second region 424. When the electronic device 101 is manufactured, depending on a disposition position of the connector 430 of the camera module 400 and a connector (e.g., a first connector 321 of the first printed circuit board 320) connected to the camera module 400 disposed in the electronic device 101, the flexible region 422 may be disposed to contact one of the first region 423 or the second region 424 of the rigid region 421. For example, in a state in which the flexible region 422 is folded to face the first region 423 of the rigid region 421, the flexible region 422 may have a shape extending in the first direction d1. For another example, in a state in which the flexible region 422 is folded to face the second region 424 of the rigid region 421, the flexible region 422 may have a shape extending in the second direction d2.

According to an embodiment, as the flexible region 422 is folded with respect to the folding axis f, the connector 430 connected to the flexible region 422 may be movable between a position facing the first edge 421a and a position facing the second edge 421b, of the rigid region 421. For example, when the flexible region 422 faces the first region 423 by being folded with respect to the folding axis f, the connector 430 may face the first edge 421a of the rigid region 421. For another example, when the flexible region 422 faces the second region 424 by being folded with respect to the folding axis f, the connector 430 may face the second edge 421b of the rigid region 421.

For example, the camera module 400 may be mounted on each of the electronic devices 101 having different internal structures. When the camera module 400 is mounted on the electronic device 101, the first connector 321 of the first printed circuit board 320 of the electronic device 101 may not be at a point corresponding to the position of the connector 430 of the camera module 400. In case that the connector 430 of the camera module 400 is not movable with respect to the rigid region 421, the connector 430 and the first connector 321 of the first printed circuit board 320 are not capable of being connected, so the camera module 400 may not be mounted in the electronic device 101. In this case, if the position of the connector 430 is changed by simply rotating the camera module 400 to correspond to a position of the first connector 321, the camera module 400 may not clearly recognize the distance to the subject in a state in which the camera module 400 is mounted on the electronic device 101. According to an embodiment, in the camera module 400, as the flexible region 422 is folded, the connector 430 may move and may be coupled to the first connector 321 disposed at various positions on the first printed circuit board 320. The camera module 400 according to an embodiment may be mounted on each of the various electronic devices 101 because the position of the connector 430 may be changed by the flexible region 422 without having to be redesigned to suit each of the electronic devices 101 having various structures.

As described above, according to an embodiment, in the camera module 400, as the flexible region 422 is folded with respect to the folding axis f, the position of the connector 430 with respect to the rigid region 421 may be changed, so that it may be possible to be mounted on each of the electronic devices 101 having various structures.

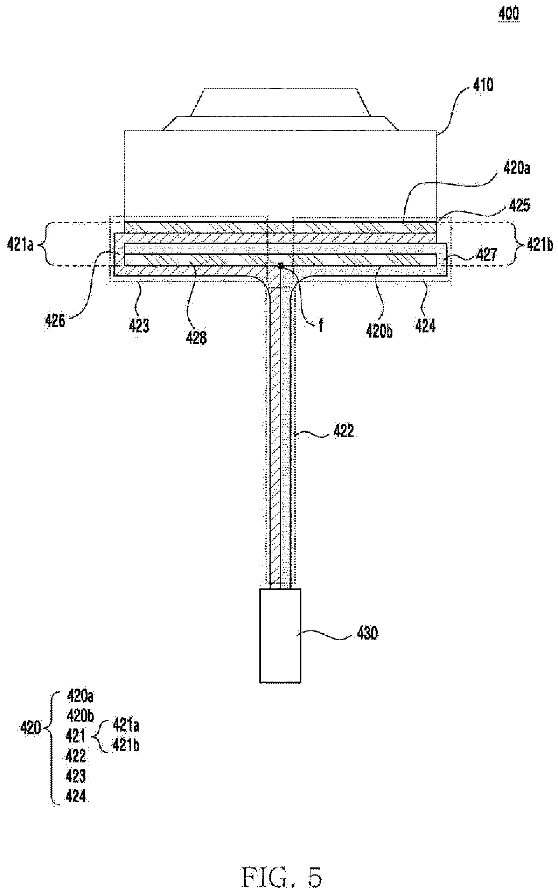

FIG. 5 is a section view illustrating an example of a camera module cut along line A-A' of FIG. 4A according to an embodiment.

FIG. 5 is a section view illustrating an example of cutting a camera module 400 of FIG. 4A along a virtual line (e.g., a line connecting a point on a first edge 421a and a point on a second edge 421b) extending in a direction perpendicular to a folding axis f.

Referring to FIG. 5, in an embodiment, the printed circuit board 420 may include a first layer 425, a second layer 426 disposed on the first layer 425, a third layer 427 disposed on the second layer, and a fourth layer 428 disposed on the third layer 427. According to an embodiment, the first layer 425, the second layer 426, the third layer 427, and the fourth layer 428 may form the printed circuit board 420, by being sequentially stacked. For example, the first layer 425 may form a top surface 420a of the printed circuit board 420 on which the camera 410 is disposed, and the fourth layer 428 may form a bottom surface 420b of the printed circuit board 420.

According to an embodiment, the first layer 425 and the fourth layer 428 may include a conductive pattern forming a ground line of the printed circuit board 420. The first layer 425 and/or the fourth layer 428 may include a material having rigidity. For example, the first layer 425 and/or the fourth layer 428 may include polyester, polycarbonate (PC), or epoxy.

According to an embodiment, the second layer 426 and the third layer 427 may include a conductive pattern forming a signal line and/or a power line of the printed circuit board 420. For example, the second layer 426 and the third layer 427 may be a passage through which an image signal generated from the camera 410 moves to the connector 430. For another example, the second layer 426 and the third layer 427 may be a path through which a signal for power supply or a signal for data transmission moves from the connector 430 to the camera 410. The second layer 426 and the third layer 427 may include a material having flexiblity. For example, the second layer 426 and/or the third layer 427 may include a resin formed of polyimide (PI) having flexiblity and lines formed of a metal thin film on the resin.

According to an embodiment, a rigid region 421 may include the first layer 425, the second layer 426, the third layer 427, and the fourth layer 428. For example, the first layer 425, the second layer 426, the third layer 427, and the fourth layer 428 may form the rigid region 421, by being sequentially stacked.

According to an embodiment, the second layer 426 and the third layer 427 may form a flexible region 422. For example, the second layer 426 may protrude from the first edge 421a and may extend along outer surfaces of the third layer 427 and the fourth layer 428 to the folding axis f. The third layer 427 may contact the second layer 426, by protruding from the second edge 421b, and extending along the outer surface of the fourth layer 428 to the folding axis f. The second layer 426 and the third layer 427 in contact with each other at the folding axis f may form the flexible region 422, by extending in a direction perpendicular to the fourth layer 428 respectively. A part of the second layer 426 and the third layer 427 forming the flexible region 422 may be folded with respect to the folding axis f in a state of maintaining the contact.

As described above, the camera module 400 according to an embodiment may be implemented by forming the flexible region 422 by extending the second layer 426 and the third layer 427 including the signal line in the direction perpendicular to the fourth layer 428. According to an embodiment, in the camera module 400, as the flexible region 422 is folded with respect to the folding axis f, a position of the connector 430 with respect to the rigid region 421 may be changed, so that it may be possible to be mounted on the electronic devices 101 having various structures.

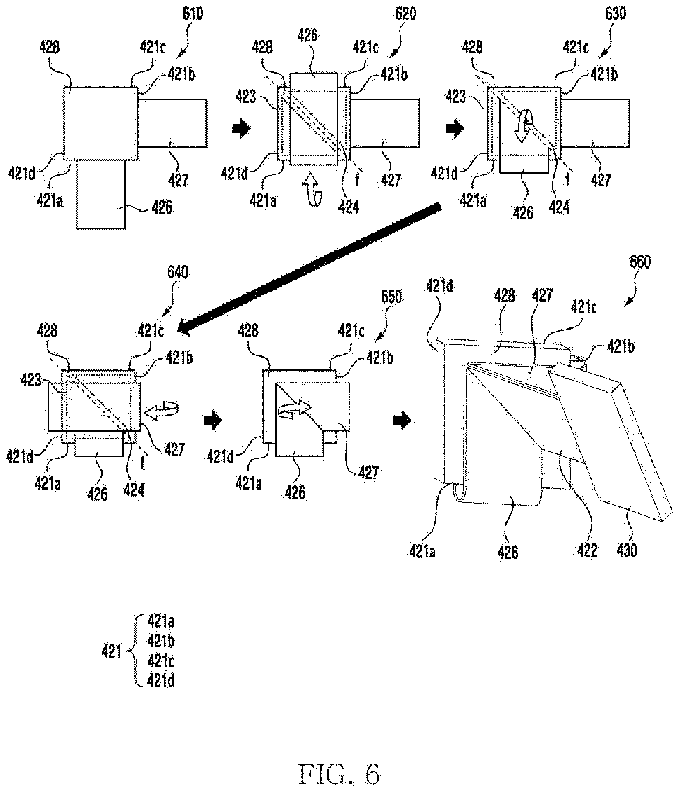

FIG. 6 illustrates an example of a method of manufacturing a camera module according to an embodiment.

Referring to FIG. 6, a manufacturing method of a camera module 400 described in FIG. 5 described above may be as follows.

In process 610, a first layer (e.g., a first layer 425 of FIG. 5), a second layer 426, a third layer 427, and a fourth layer 428 may be sequentially stacked. The second layer 426 may have a shape extending from a first edge 421a in a direction in which the first edge 421a faces. The third layer 427 may have a shape extending from a second edge 421b in a direction in which the second edge 421b faces.

In process 620, the second layer 426 may be folded in a direction toward a third edge 421c with respect to the first edge 421a. In a folded state, the second layer 426 may face a first region 423 and a second region 424, and a part of the second layer 426 may be bonded to the fourth layer 428 positioned on the first region 423.

In process 630, the second layer 426 may be folded to face the first edge 421a with respect to a folding axis f. For example, the remaining part of the second layer 426, excluding the part bonded to the fourth layer 428, may be folded with respect to the folding axis f. In the folded state, the second layer 426 may face only the first region 423 of a rigid region 421.

In process 640, the third layer 427 may be folded in a direction toward a fourth edge 421d with respect to the second edge 421b. In the folded state, the third layer 427 may face the first region 423 and the second region 424 of the rigid region 421, and a part of the third layer 427 may be bonded to the fourth layer 428 positioned on the second region 424.

In the process 640, the third layer 427 may be folded to face the second edge 421b with respect to the folding axis f. For example, the remaining part of the third layer 427, excluding the part bonded to the fourth layer 428, may be folded based on the folding axis f. In the folded state, the third layer 427 may face only the second region 424. The second layer 426 and the third layer 427 may have a line-symmetric shape with respect to the folding axis f.

In state 650, the second layer 426 and the third layer 427 may be bonded, by being aligned in a direction perpendicular to the fourth layer 428. For example, the second layer 426 and the third layer 427 may be bonded through an adhesive material, but are not limited thereto.

In state 660, after the second layer 426 and the third layer 427 are bonded, the second layer 426 and the third layer 427 may form a flexible region 422. The connector 430 may be connected to one end of the second layer 426 and the third layer 427. When the camera 410 is disposed on the rigid region 421 after the connector 430 is connected to the second layer 426 and the third layer 427, manufacturing of the camera module (e.g., the camera module 400 of FIG. 4) may be completed.

As described above, according to an embodiment, in the camera module 400, as the flexible region 422 is folded with respect to the folding axis f, a position of the connector 430 with respect to the rigid region 421 may be changed, so that it may be possible to be mounted on the electronic devices 101 having various structures.

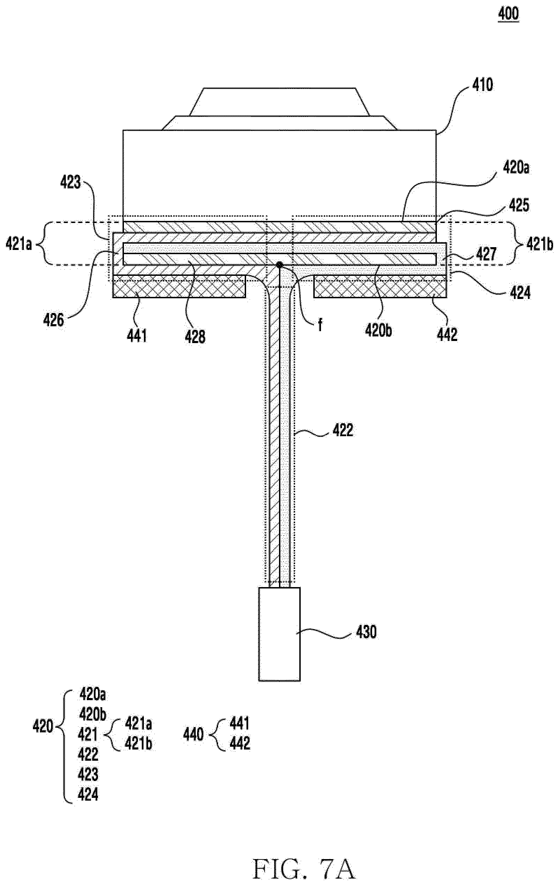

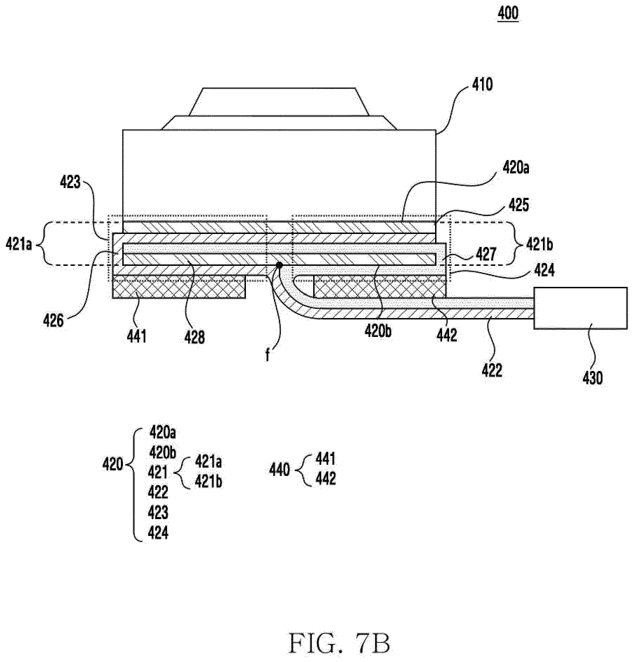

FIG. 7A is a section view illustrating a cross-section of a camera module according to an embodiment. FIG. 7B is a diagram illustrating an example of a state in which a flexible region of a camera module is folded according to an embodiment.

A camera module 400 of FIGS. 7A and 7B may be the camera module 400 to which an adhesive member 440 is added from the camera module 400 of FIG. 4, and a redundant description will be omitted.

According to an embodiment, the camera module 400 may further include the adhesive member 440. The adhesive member 440 may maintain a folded state of a flexible region 422. According to an embodiment, the adhesive member 440 may be disposed on a bottom surface 420b of a printed circuit board 420. For example, the adhesive member 440 may be disposed on a part of the second layer 426 and a part of the third layer 427 that are in contact with the bottom surface 420b of the printed circuit board 420.

According to an embodiment, the adhesive member 440 may be disposed to be symmetrical with respect to a folding axis f. For example, the adhesive member 440 may include a first adhesive member 441 disposed on a part of the second layer 426 located on a first region 423 and a second adhesive member 442 disposed on a part of the third layer 327 located on a second region 424. The first adhesive member 441 and the second adhesive member 442 may surround the flexible region 422 by facing each other with respect to the folding axis f.

According to an embodiment, the adhesive member 440 may contact a part of the flexible region 422 in a state in which the flexible region 422 is folded. For example, the flexible region 422 may be folded to face the first region 423 with respect to the folding axis f. In a state in which the flexible region 422 is folded to face the first region 423, the first adhesive member 441 disposed on a part of the second layer 426 may be in contact with the flexible region 422 and may be adhered to the flexible region 422. The first adhesive member 441 adhered to the flexible region 422 may maintain the folded state of the flexible region 422. As the first adhesive member 441 maintains the folded state of the flexible region 422, a position of a connector 430 may be fixed at a position facing a first edge 421a. For another example, the flexible region 422 may be folded to face the second region 424 with respect to the folding axis f. In a state in which the flexible region 422 is folded to face the second region 424, the second adhesive member 442 disposed on the part of the third layer 427 may be adhered to the flexible region 422 by contacting the flexible region 422. The second adhesive member 442 attached to the flexible region 422 may maintain the folded state of the flexible region 422. As the second adhesive member 442 maintains the folded state of the flexible region 422, the position of the connector 430 may be fixed to a position facing the second edge 421b.

For example, in case that the folded state of the flexible region 422 is not maintained, the flexible region 422 may be unfolded by being restored. When the flexible region 422 is unfolded, the camera module 400 may deviate from its design position in the electronic device (e.g., an electronic device 101 of FIG. 1). The camera module 400 according to an embodiment may not deviate from its design position in the electronic device 101, by maintaining the folded state of the flexible region 422, by including the adhesive member 440.

According to an embodiment, the adhesive member 440 may relieve stress acting on the flexible region 422 in the state in which the flexible region 422 is folded. For example, in the state in which the flexible region 422 is folded, a part 422a of the flexible region 422 adjacent to the folding axis f may be bent to have a curvature. When the part 422a of the flexible region 422 is bent, stress may be generated in the flexible region 422, and the stress may increase as the curvature of the part 422a of the flexible region 422 is smaller. By having a thickness, the adhesive member 440 may reduce the magnitude of the stress acting on the flexible region 422, by reducing the curvature of the part 422a of the flexible region 422.

As described above, according to an embodiment, since the folded state of the flexible region 422 is maintained by the adhesive member 440, the camera module 400 may not deviate from its design position when the camera module 400 is mounted on the electronic device 101. A lifespan of the camera module 400 according to an embodiment may be increased by relieving stress generated in the flexible region 422 when folded by the adhesive member 440.

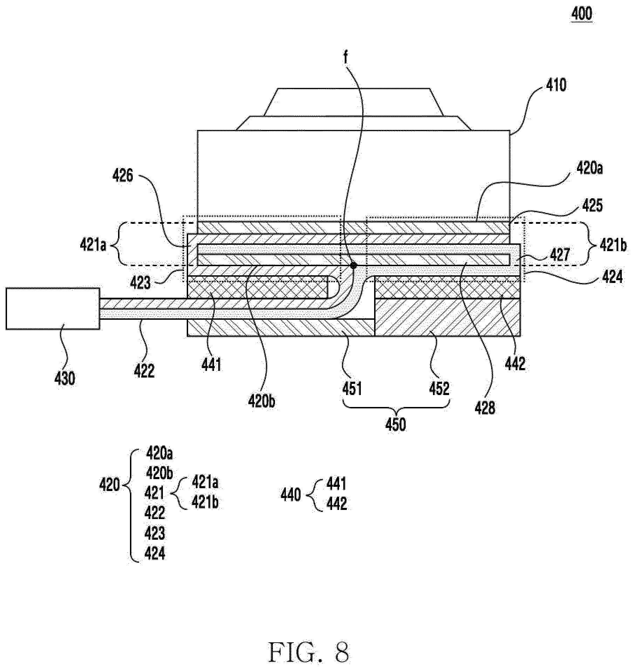

FIG. 8 is a diagram illustrating an example of a state in which a flexible region of a camera module is folded according to an embodiment.

Since a camera module 400 of FIG. 8 may be the camera module 400 to which a support member 450 is added from the camera module 400 of FIG. 7A and/or FIG. 7B, a redundant description will be omitted.

Referring to FIG. 8, the camera module 400 may further include the support member 450. The support member 450 may support the camera module 400 in a state in which a flexible region 422 is folded. According to an embodiment, the support member 450 may be coupled on a bottom surface 420b of a printed circuit board 420. For example, the support member 450 may include a first portion 451 and a second portion 452 forming a step with the first portion 451. The first portion 451 may be disposed on one region among a first region 423 and a second region 424 that faces the flexible region in a folded state, and the second portion 452 may be disposed on the other region among the first region 423 and the second region 424. For example, when the flexible region 422 is folded to face the first region 423, the first portion 451 may be disposed on the first region 423, and the second portion 452 may be disposed on the second region 424 not facing the flexible region 422 in the folded state.

According to an embodiment, the support member 450 may remove a step that occurs between the first region 423 and the second region 424 as the flexible region 422 is folded. For example, when the flexible region 422 is folded to face the first region 423, a thickness of the camera module 400 in the first region 423 may be greater than a thickness of the camera module 400 in the second region 424, due to the folded flexible region 422. If a thickness difference between the camera module 400 on the first region 423 and the second region 424 occurs, when the camera module 400 is mounted on an electronic device (e.g., an electronic device 101 of FIG. 1), the camera module 400 may not maintain a designed position of the electronic device 101. According to an embodiment, the camera module 400 may prevent the camera module 400 from deviating from its designed position in the electronic device 101, by including the support member 450 that compensates for the step between the first region 423 and the second region 424 caused by the folding of the flexible region 422.

As described above, according to an embodiment, the camera module 400 may be stably mounted on the electronic device 101 by removing the step between the first region 423 and the second region 424 that occurs as the flexible region 422 is folded by the support member 450.

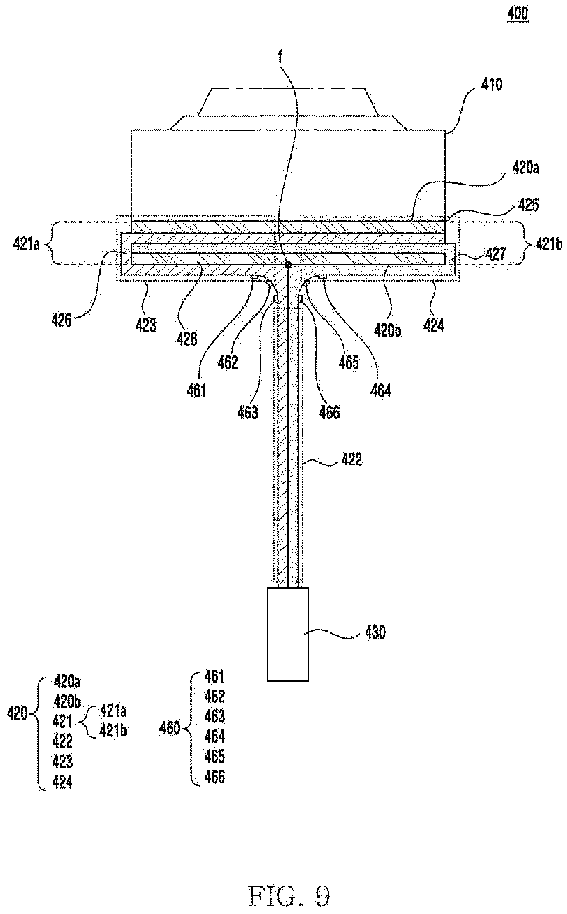

FIG. 9 is a section view illustrating a cross-section of a camera module according to an embodiment.

A camera module 400 of FIG. 9 may be the camera module 400 to which a reinforcing member 460 is added from the camera module 400 of FIG. 4, and a redundant description will be omitted.

Referring to FIG. 9, in an embodiment, the camera module 400 may further include the reinforcing member 460. The reinforcing member 460 may enhance durability of a flexible region 422 by having a different rigidity from that of the flexible region 422. According to an embodiment, the reinforcing member 460 may be disposed in a part 422a of the flexible region 422 adjacent to a folding axis f. For example, the reinforcing member 460 may be disposed in a part of a second layer 426 and a part of a third layer 427 adjacent to the folding axis f.

According to an embodiment, the reinforcing member 460 may include a plurality of reinforcing members 461, 462, 463, 464, 465, and 466. The plurality of reinforcing members 461, 462, 463, 464, 465, and 466 may be spaced apart from each other. For example, the plurality of reinforcing members 461, 462, and 463 disposed on the second layer 426 may be disposed to be spaced apart from each other along an extension direction of the second layer 426. For another example, the plurality of reinforcing members 464, 465, and 466 disposed on the third layer 427 may be disposed to be spaced apart from each other along an extension direction of the third layer 427.

For example, the part 422a of the flexible region 422 adjacent to the folding axis f may be a portion of the flexible region 422 that receives the most stress generated due to folding of the flexible region 422. When the plurality of reinforcing members 461, 462, 463, 464, 465, and 466 are disposed to be spaced apart from each other in the part 422a of the flexible region 422, a section having flexibility and a section having rigidity may be sequentially repeated in the part 422a of the flexible region 422. As the flexible section and the rigid section are repeated, the durability of the part 422a of the flexible region may be increased.

As described above, by including the reinforcing member 460 that reinforces a rigidity of the part 422a of the flexible region 422 adjacent to the folding shaft f, the overall durability is increased, a lifespan of the camera module 400 according to an embodiment may be increased.

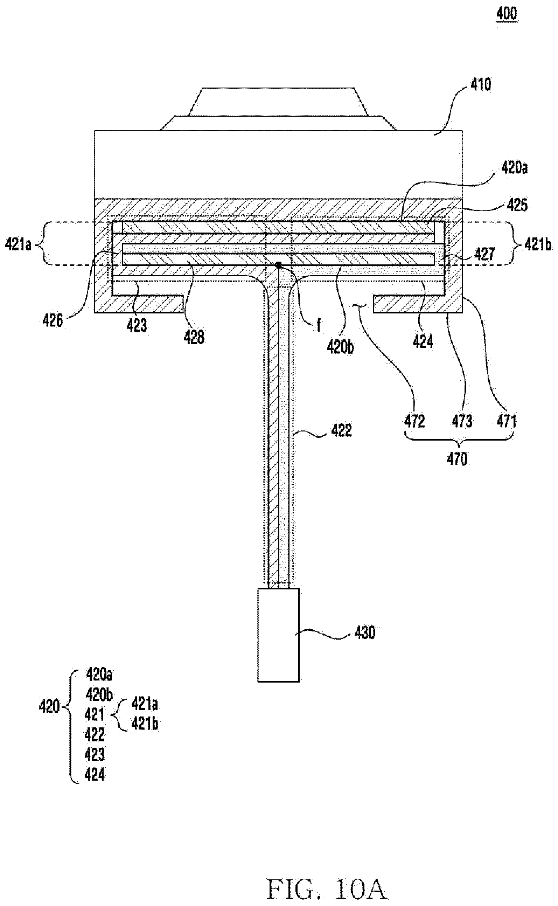

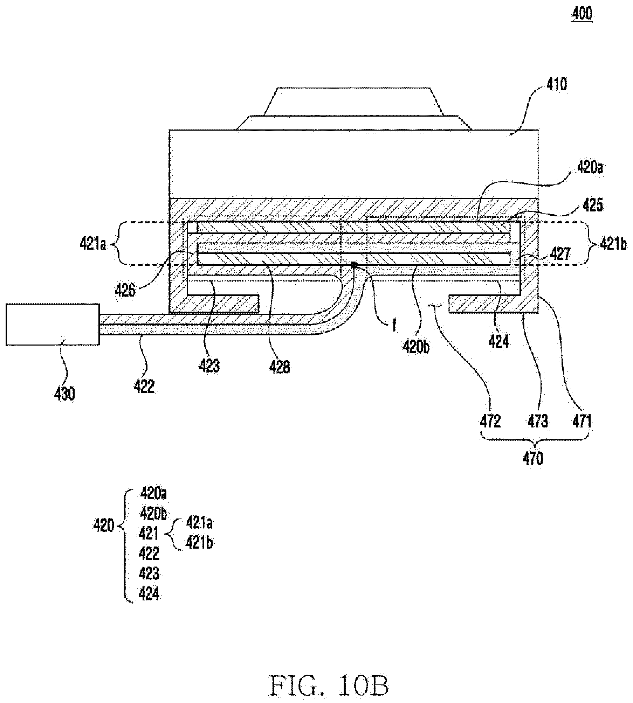

FIG. 10A is a section view illustrating a cross-section of a camera module according to an embodiment, and FIG. 10B is a diagram illustrating an example of a state in which a flexible region of a camera module is folded according to an embodiment.

A camera module 400 of FIGS. 10A and/or 10B may be the camera module 400 to which a seating member 470 is added from the camera module 400 of FIG. 4, and a redundant description will be omitted.

Referring to FIGS. 10A and 10B, in an embodiment, the camera module 400 may further include the seating member 470. The seating member 470 may support a flexible region 422 in a folded state. According to an embodiment, the seating member 470 may be disposed to surround the printed circuit board 420 on the outside of the printed circuit board 420. For example, a part of a case (e.g., a case 411 of FIG. 4) may form the seating member 470 by extending along an outer surface of the printed circuit board 420 in a direction from a top surface 420a toward a bottom surface 420b of the printed circuit board 420. For another example, a part of a shield can (e.g., a shield can 414 of FIG. 4) may form the seating member 470 by extending along the outer surface of the printed circuit board 420 in the direction from the top surface 420a toward the bottom surface 420b of the printed circuit board 420.

According to an embodiment, a part 471 of the seating member 470 may be spaced apart from the bottom surface 420b of the printed circuit board 420. For example, the part 471 of the seating member 470 may be spaced apart from the bottom surface 420b of the printed circuit board 420 along the direction from the top surface 420a toward the bottom surface 420b of the printed circuit board 420.

According to an embodiment, the seating member 470 may include a passing hole 472 through which the flexible region 422 may pass. A part of the flexible region 422 may pass through the through hole 472 in an unfolded state and may be located outside the seating member 470.

According to an embodiment, the flexible region 422 may contact an outer surface 473 of the seating member 470 as it is folded with respect to a folding axis f. For example, the outer surface 473 of the seating member 470 may be spaced apart from a part of a second layer 426 disposed on a first region 423 and a part of a third layer 427 disposed on a second region 424. In a state in which the flexible region 422 is folded, the flexible region 422 may have a curvature and may be bent. As the curvature of the flexible region 422 is smaller, stress generated as the flexible region 422 is folded may increase. In case that the camera module 400 includes the seating member 470, since the flexible region 422 is supported by the outer surface 473 of the seating member 470 spaced apart from the bottom surface 420b of the printed circuit board 420, the flexible region 422 may be bent to have a relatively greater curvature than the case that it does not include the seating member 470. As the flexible region 422 is bent to have the relatively greater curvature, the stress generated as the flexible region 422 is folded may decrease.

As described above, according to an embodiment, the camera module 400 may reduce stress generated inside the flexible region 422 by including the seating member 470 that increases the curvature of the flexible region 422 in the folded state. According to an embodiment, as the stress generated inside the flexible region 422 is reduced, a lifespan of the camera module 400 may be increased.

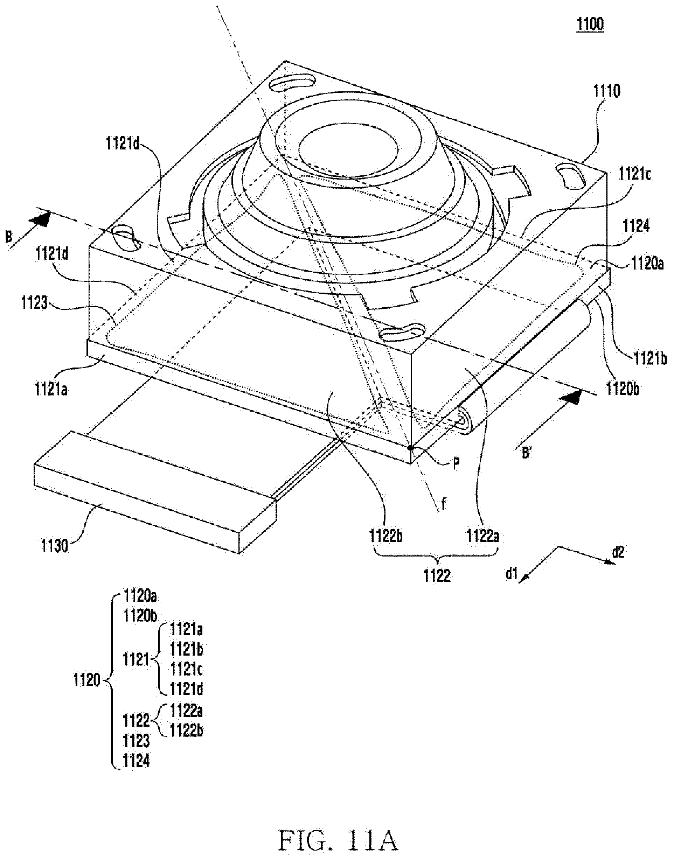

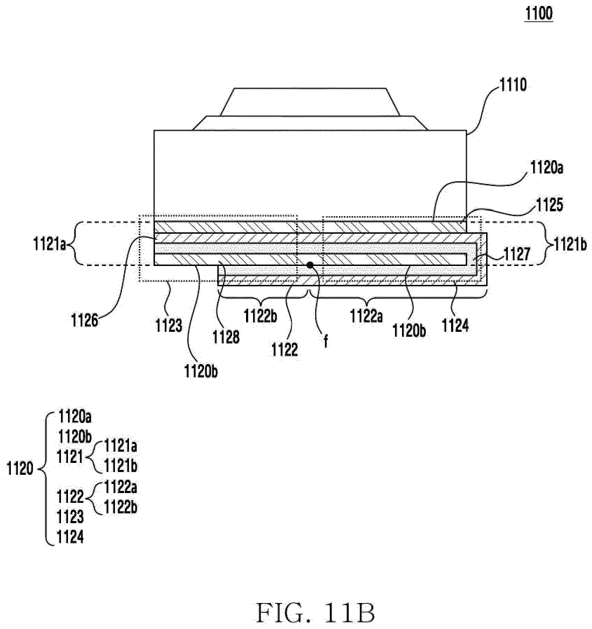

FIG. 11A is a diagram illustrating an example of a state in which a flexible region of a camera module is unfolded, according to an embodiment, and FIG. 11B is a section view illustrating an example of a camera module cut along line B-B' of FIG. 11A according to an embodiment.

Referring to FIGS. 11A and 11B, in an embodiment, a camera module 1100 may include a camera 1110, a printed circuit board 1120, and a connector 1130. The camera 1110, the printed circuit board 1120, and the connector 1130 of FIG. 11 may be substantially the same as a camera 410, a printed circuit board 420, and a connector 430 of FIG. 4, so a description will be omitted in a duplicating range.

According to an embodiment, the printed circuit board 1120 may include a top surface 1120a on which the camera 1110 is disposed and the other surface 1120b facing the top surface 1120a.

According to an embodiment, the printed circuit board 1120 may include a rigid region 1121 having rigidity and a flexible region 1122 having flexibility. The flexible region 1122 may be foldable with respect to a folding axis f. According to an embodiment, the folding axis f may be a virtual line passing through a point p at which a first edge 1121a and a second edge 1121b contact each other. For example, the folding axis f may be a virtual line extending in a direction parallel to a diagonal of the rigid region 1121, but is not limited thereto. For example, the folding axis f may be a line passing through one of the point p at which the first edge 1121a and the second edge 1121b contact each other and a point of a third edge 1121c. For another example, the folding axis f may be a line passing through one of the point p at which the first edge 1121a and the second edge 1121b contact each other and a point of a fourth edge 1121d.

According to an embodiment, the rigid region 1121 may include a first region 1123 and a second region 1124 facing each other with respect to the folding axis f.

According to an embodiment, a state in which the flexible region 1122 is unfolded may mean that a part 1122a of the flexible region 1122 and another part 1122b of the flexible region 1122 are disposed to face the same direction. In the state in which the flexible region 1122 is unfolded, the part 1122a of the flexible region 1122 may be disposed on a bottom surface 1120b of the printed circuit board 1120, by being bent from the second edge 1121b. In the state in which the flexible region 1122 is unfolded, the other part 1122b of the flexible region 1122 may extend along a direction toward which the first edge 1121a faces from the folding axis f. For example, in the state in which the flexible region 1122 is unfolded, the part 1122a of the flexible region 1122 may face the second region 1124 of the rigid region 1121, and the other part 1122b of the flexible region 1122 may face the first region 1123 of the rigid region 1121.

According to an embodiment, the connector 1130 may be connected to the other part 1122b of the flexible region 1122. In the state in which the flexible region 1122 is unfolded, the connector 1130 may face the first edge 1121a.

Referring to FIG. 11B, in an embodiment, the printed circuit board 1120 may include a first layer 1125, a second layer 1126 disposed on the first layer 1125, a third layer 1127 disposed on the second layer 1126, and a fourth layer 1128 disposed on the third layer 1127. According to an embodiment, the first layer 1125, the second layer 1126, the third layer 1127, and the fourth layer 1128 may form the printed circuit board 1120, by being sequentially stacked. For example, the first layer 1125 may form the top surface 1120a of the printed circuit board 1120 on which the camera 1110 is disposed, and the fourth layer 1128 may form the bottom surface 1120b of the printed circuit board 1120.

According to an embodiment, the first layer 1125 and the fourth layer 1128 may include a conductive pattern forming a ground line of the printed circuit board 1120.

According to an embodiment, the second layer 1126 and the third layer 1127 may include a conductive pattern forming a signal line of the printed circuit board 1120. For example, the second layer 1126 and the third layer 1127 may be a path through which an image signal generated from the camera 1110 moves to the connector 1130. For another example, the second layer 1126 and the third layer 1127 may be a path through which a signal for power supply or a signal for data transmission moves from the connector 1130 to the camera module 1100.

According to an embodiment, the rigid region 1121 may be formed by the first layer 1125, the second layer 1126, the third layer 1127, and the fourth layer 1128. The flexible region 1122 may be formed by the second layer 1126 and the third layer 1127. For example, the second layer 1126 and the third layer 1127 may form the flexible region 1122, by protruding from the second edge 1121b. The second layer 1126 and the third layer 1127 may be located on the bottom surface 1120b of the printed circuit board 1120 along an outer surface of the fourth layer 1128, by being bent from the second edge 1121b.

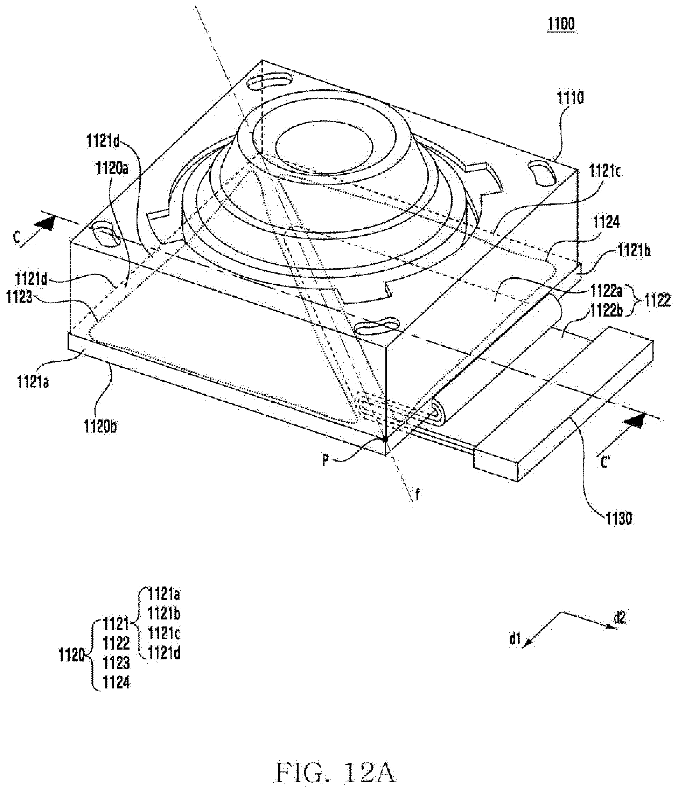

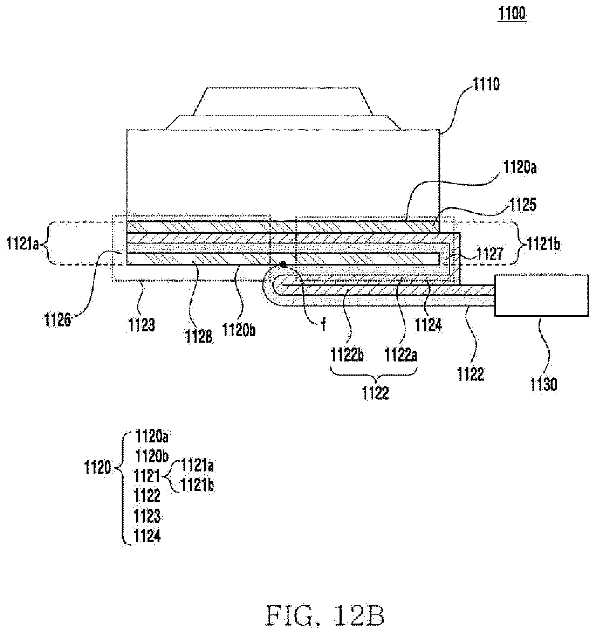

FIG. 12A is a diagram illustrating an example of a state in which a flexible region of a camera module is folded according to an embodiment, and FIG. 12B is a section view illustrating an example of a camera module cut along line C-C' of FIG. 12A according to an embodiment.

Referring to FIGS. 12A and 12B, in an embodiment, a state in which the flexible region 1122 is folded may mean that a part 1122a of the flexible region 1122 and another part 1122b of the flexible region 1122 are disposed to face different directions. For example, in the state in which the flexible region 1122 is folded, the part 1122a of the flexible region 1122 and the other part 1122b of the flexible region 1122 may face opposite directions each other, by facing each other. In the state in which the flexible region 1122 is folded, the other part 1122b of the flexible region 1122 may face only a second region 1124 without facing a first region 1123.

According to an embodiment, in the state in which the flexible 1122 is folded, a connector 1130 connected to the other part 1122b of the flexible region 1122 may face a second edge 1121b.

As described above, according to an embodiment, as the flexible region 1122 is folded with respect to the folding axis f, a position of the connector 1130 with respect to the rigid region 1121 may change, so the camera module 1100 may be possible to be mounted on an electronic device (e.g., an electronic device 101 of FIG. 1) having various structures.

According to an embodiment, a camera module (e.g., a camera module 400 of FIG. 4A) may comprise a camera (e.g., a camera 410 of FIG. 4A), a printed circuit board (e.g., a printed circuit board 420 of FIG. 4A) on which the camera is disposed, including a rigid region (e.g., a rigid region 421 of FIG. 4A) including a first edge (e.g., a first edge 421a of FIG. 4A) and a second edge (e.g., a second edge 421b of FIG. 4A) extending perpendicular to the first edge and a flexible region (e.g., a flexible region 422 of FIG. 4A) extending from the rigid region, and a connector (e.g., a connector 430 of FIG. 4A) connected to the flexible region of the printed circuit board, and the flexible region may by foldable on one surface (e.g., a bottom surface 420b of FIG. 4A) of the printed circuit board with respect to a folding axis (e.g., a folding axis f of FIG. 4A) passing through a point where the first edge and the second edge contact, and the connector may be movable between a position facing the first edge and a position facing the second edge as the flexible region is folded with respect to the folding axis.

According to an embodiment, the flexible region may extend from the one surface of the printed circuit board in a direction perpendicular to the one surface of the printed circuit board.

According to an embodiment, the rigid region may include a first region (e.g., a first region 423 of FIG. 4A) and a second region (e.g., a second region 424 of FIG. 4A) facing the first region with respect to the folding axis, and the connector may face the first edge when the flexible region faces the first region, may face the second edge when the flexible region faces the second region.

According to an embodiment, the camera module may comprise a supporting member (e.g., a supporting member 450 of FIG. 8) including a first portion (e.g., a first portion 451 of FIG. 8) and a second portion (e.g., a second portion 452 of FIG. 8) forming a step with the first portion, the first portion may be disposed on one region among the first region and the second region that faces the flexible region in a folded state, and the second portion may be disposed on the other region among the first region and the second region.

According to an embodiment, a part of the flexible region may be bent from the second edge and disposed on the one surface of the flexible circuit board, and the connector may be connected to another part of the flexible region, may face the first edge when the part of the flexible region is in an unfolded state and may face the second edge when the part of the flexible region is in a folded state with respect to the folding axis.

According to an embodiment, the camera module may further comprise an adhesive member (e.g., an adhesive member 440 of FIG. 7A) disposed on the one surface of the printed circuit board, and the adhesive member may limit the movement of the flexible region by contacting with a part of the flexible region when the flexible region is in a folded state.

According to an embodiment, the adhesive member may be disposed on the one surface of the printed circuit board to be symmetrical with respect to the folding axis.

According to an embodiment, the camera module may further comprise a reinforcing member (e.g., a reinforcing member 460 of FIG. 9) having different rigidity from the flexible region and disposed on a part of the flexible region adjacent to the folding axis.

According to an embodiment, the reinforcing member may be a plurality, and the plurality of the reinforcing member (e.g., a plurality of reinforcing members 461, 462, 463, 464, 465, and 466 of FIG. 9) may be disposed in the part of the flexible region and spaced apart from each other.

According to an embodiment, the camera module may further comprise a seating member (e.g., a seating member 470 of FIG. 10) including a passing hole (e.g., a passing hole 472 of FIG. 10) which the flexible region passes, a part (e.g., a part 471 of FIG. 10) of the sealing member spaced apart from the one surface of the printed circuit board, and the flexible region may contact an outer surface (e.g., an outer surface 473 of FIG. 10) of the seating member as folded with respect to the folding axis.

According to an embodiment, the rigid region may further include a first layer (e.g., a first layer 425 of FIG. 5), a second layer (e.g., a second layer 426 of FIG. 5) disposed on the first layer, a third layer (e.g., a third layer 427 of FIG. 5) disposed on the second layer, and a fourth layer (e.g., a fourth layer 428 of FIG. 5) disposed on the third layer, and the second layer and the third layer may extend from the rigid region and form the flexible region.

According to an embodiment, the printed circuit board may further include signal lines respectively formed on the second layer and the third layer.

According to an embodiment, the second layer may extend from the first edge to the folding axis along an outer surface of the fourth layer, and the third layer may extend from the second edge to the folding axis along the outer surface of the fourth layer, and may be in contact with the second layer.

According to an embodiment, an electronic device may comprise a housing (e.g., a housing 310 of FIG. 3), a first printed circuit board (e.g., a first printed circuit board 320 of FIG. 3) disposed inside the housing, and a camera module (e.g., a camera module 400 of FIG. 4A) disposed inside the housing, and the camera module may include a camera (e.g., a camera 410 of FIG. 4A). According to an embodiment, the camera module may include a printed circuit board (e.g., a printed circuit board 420 of FIG. 4A) on which the camera is disposed, including a rigid region (e.g., a rigid region 421 of FIG. 4A) including a first edge (e.g., a first edge 421a of FIG. 4A) and a second edge (e.g., a second edge 421b of FIG. 4A) extending perpendicular to the first edge and a flexible region (e.g., a flexible region 422 of FIG. 4A) extending from the rigid region, and a connector (e.g., a connector 430 of FIG. 4A) connected to the flexible region of the printed circuit board, and the flexible region may be foldable on one surface (e.g., a bottom surface 420b of FIG. 4A) of the printed circuit board with respect to a folding axis (e.g., a folding axis f of FIG. 4A) passing through a point where the first edge and the second edge contact, and the connector may be movable between a position facing the first edge and a position facing the second edge as the flexible region is folded with respect to the folding axis.

According to an embodiment, the flexible region may extend from the one surface of the printed circuit board in a direction perpendicular to the one surface of the printed circuit board.

According to an embodiment, the rigid region may include a first region (e.g., a first region 423 of FIG. 4A) and a second region (e.g., a second region 424 of FIG. 4A) facing the first region with respect to the folding axis, and the connector may face the first edge when the flexible region faces the first region, may face the second edge when the flexible region faces the second region.

According to an embodiment, the camera module may comprise a supporting member (e.g., a supporting member 450 of FIG. 8) including a first portion (e.g., a first portion 451 of FIG. 8) and a second portion (e.g., a second portion 452 of FIG. 8) forming a step with the first portion, the first portion may be disposed on one region among the first region and the second region that faces the flexible region in a folded state, and the second portion may be disposed on the other region among the first region and the second region.

According to an embodiment, the camera module may further comprise an adhesive member (e.g., an adhesive member 440 of FIG. 7A) disposed on the one surface of the printed circuit board, and the adhesive member may limit the movement of the flexible region by contacting with a part of the flexible region when the flexible region is in a folded state.

According to an embodiment, the camera module may further comprise a reinforcing member (e.g., a reinforcing member 460 of FIG. 9) having different rigidity from the flexible region and disposed on a part of the flexible region adjacent to the folding axis.

According to an embodiment, the camera module may further comprise a seating member (e.g., a seating member 470 of FIG. 10) including a passing hole (e.g., a passing hole 472 of FIG. 10) which the flexible region passes, a part (e.g., a part 471 of FIG. 10) of the sealing member spaced apart from the one surface of the printed circuit board, and the flexible region may contact an outer surface (e.g., an outer surface 473 of FIG. 10) of the seating member as folded with respect to the folding axis.

The electronic device according to various embodiments disclosed in the present document may be various types of devices. The electronic device may include, for example, a portable communication device (e.g., a smartphone), a computer device, a portable multimedia device, a portable medical device, a camera, an electronic device, or a home appliance. The electronic device according to an embodiment of the present document is not limited to the above-described devices.

The various embodiments of the present document and terms used herein are not intended to limit the technical features described in the present document to specific embodiments, and should be understood to include various modifications, equivalents, or substitutes of the embodiment. In relation to the description of the drawings, a similar reference numeral may be used for a similar or related component. The singular form of the noun corresponding to the item may include one or a plurality of items unless explicitly indicated differently in the context involved. In the present document, each of the phrases such as "A or B", "at least one of A and B", "at least one of A or B", "A, B or C", "at least one of A, B and C", and "at least one of A, B or C" may include any one among the items listed together with the corresponding phrase among the phrases, or all possible combinations thereof. Terms such as "1st", "2nd", or "the first", or "the second" may be used simply to distinguish a corresponding component from another corresponding component, and do not limit the corresponding component to other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

The term "module" used in various embodiments of the present document may include units implemented in hardware, software, or firmware, and may be used interchangeably with terms such as logic, logic block, component, or circuit, for example. The module may be an integrally configured component or a minimum unit of the component or a part thereof that performs one or more functions. For example, according to an embodiment, the module may be implemented in the form of an application-specific integrated circuit (ASIC).

Various embodiments of the present document may be implemented as a software (e.g., a program 140) including one or more instructions stored in a storage medium (e.g., an internal memory 136 or an external memory 138) that may be read by a machine (e.g., an electronic device 101). For example, a processor (e.g., a processor 120) of the machine (e.g., the electronic device 101) may call at least one instruction among one or more instructions stored from the storage medium and execute it. This makes it possible for the machine to be operated to perform at least one function according to the at least one instruction called. The one or more instructions may include code generated by a compiler or code that may be executed by an interpreter. The machine-readable storage medium may be provided in the form of a non-transitory storage medium. Here, 'non-transitory' only means that the storage medium is a tangible device and does not include a signal (e.g., electromagnetic waves), and this term does not distinguish between a case where data is semi-permanently stored in the storage medium and a case where data is temporarily stored.

According to an embodiment, a method according to various embodiments disclosed in the present document may be included in a computer program product and provided. The computer program product may be traded between a seller and a buyer as a product. The computer program product may be distributed in the form of machine-readable storage medium (e.g., compact disc read only memory (CD-ROM)), or may be distributed (e.g., downloaded or uploaded) online, through an application store (e.g., Play Store^{™}) or directly between two user devices (e.g., smartphones). In case of the online distribution, at least a portion of the computer program product may be at least temporarily stored or temporarily generated in the machine-readable storage medium, such as the memory of a manufacturer's server, an application store's server, or a relay server.

According to various embodiments, each component (e.g., module or program) of the above-described components may include a single or plural entity, and some of the plurality of entities may be separately disposed in other components. According to various embodiments, one or more components among the above-described corresponding components or operations may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A camera module comprising:
a camera;
a printed circuit board on which the camera is disposed, including a rigid region including a first edge and a second edge extending perpendicular to the first edge and a flexible region extending from the rigid region; and
a connector connected to the flexible region of the printed circuit board,
wherein the flexible region is foldable on one surface of the printed circuit board with respect to a folding axis passing through a point where the first edge and the second edge contact, and
wherein the connector is movable between a position facing the first edge and a position facing the second edge as the flexible region is folded with respect to the folding axis.

2. The camera module of claim 1,
wherein the flexible region extends from the one surface of the printed circuit board in a direction perpendicular to the one surface of the printed circuit board.

3. The camera module of any one of claims 1 and 2,
wherein the rigid region includes a first region and a second region facing the first region with respect to the folding axis, and
wherein the connector faces the first edge when the flexible region faces the first region, faces the second edge when the flexible region faces the second region.

4. The camera module of any one of claims 1 to 3, further comprising a supporting member including a first portion and a second portion forming a step with the first portion,
wherein the first portion disposed on one region among the first region and the second region that faces the flexible region in a folded state, and
wherein the second portion disposed on the other region among the first region and the second region.

5. The camera module of any one of claims 1 to 4,
wherein a part of the flexible region is bent from the second edge and disposed on the one surface of the printed circuit board, and
wherein the connector is connected to another part of the flexible region, faces the first edge when the part of the flexible region is in an unfolded state and faces the second edge when the part of the flexible region is in a folded state with respect to the folding axis.

6. The camera module of any one of claims 1 to 5, further comprising an adhesive member disposed on the one surface of the printed circuit board,
wherein the adhesive member limits the movement of the flexible region by contacting with a part of the flexible region when the flexible region is in a folded state.

7. The camera module of any one of claims 1 to 6,
wherein the adhesive member is disposed on the one surface of the printed circuit board to be symmetrical with respect to the folding axis.

8. The camera module of any one of claims 1 to 7, further comprising a reinforcing member having different rigidity from the flexible region and disposed on a part of the flexible region.

9. The camera module of any one of claims to 8,
wherein the reinforcing member is a plurality, and
wherein the plurality of the reinforcing member is disposed in the part of the flexible region and spaced apart from each other.

10. The camera module of any one of claims 1 to 9, further comprising a seating member including a passing hole which the flexible region passes, a part of the sealing member spaced apart from the one surface of the printed circuit board, and
wherein the flexible region contacts an outer surface of the seating member as folded with respect to the folding axis.

11. The camera module of any one of claims 1 to 10, wherein the rigid region includes a first layer, a second layer disposed on the first layer, a third layer disposed on the second layer, a fourth layer disposed on the third layer, and
wherein the second layer and the third layer extend from the rigid region and form the flexible region.

12. The camera module of any one of claims 1 to 11,
wherein the printed circuit board further includes signal lines respectively formed on the second layer and the third layer.

13. The camera module of any one of claims 1 to 12,
wherein the second layer extends from the first edge to the folding axis along an outer surface of the fourth layer, and
wherein the third layer extends from the second edge to the folding axis along the outer surface of the fourth layer, and is in contact with the second layer.

14. An electronic device comprising:
a housing;
a first printed circuit board disposed inside the housing; and
a camera module disposed inside the housing,
wherein the camera module includes:
a camera;
a second printed circuit board on which the camera is disposed, including a rigid region including a first edge and a second edge extending perpendicular to the first edge and a flexible region extending from the rigid region; and
a connector connected to one end of the flexible region and electrically connecting the camera module and the first printed circuit board;
wherein the flexible region is foldable on one surface of the second printed circuit board with respect to a folding axis passing through a point where the first edge and the second edge contact, and
wherein the connector is movable between a position facing the first edge and a position facing the second edge as the flexible region is folded with respect to the folding axis.

15. The electronic device of claim 14,
wherein the flexible region extends from the one surface of the second printed circuit board in a direction perpendicular to the one surface of the second printed circuit board.
